# EUROPEAN PATENT APPLICATION

(11) **EP 4 568 056 A1**
(43) Date of publication of application: **11.06.2025**
(21) Application number: 24195397.5
(22) Date of filing: 20.08.2024
(51) Int. Cl.: H02J 7/00, H01M 10/42, H01M 10/44

(54) **BATTERY PACK GROUP AND DRIVING METHOD THEREOF**

(30) Priority: 08.12.2023 KR 20230177435
(71) Applicant: SAMSUNG SDI CO., LTD., Yongin-si, Gyeonggi-do 17084 (KR)
(72) Inventor: Jin, Kyong Pil, Yongin-si, Gyeonggi-do 17084 (KR); Kim, Ha Neul, Yongin-si, Gyeonggi-do 17084 (KR)
(74) Representative: Gulde & Partner

(57) **Abstract**

A battery pack group (100) includes a first battery pack (Pack1), the first battery pack (Pack1) including a first battery cell group (Cell1) in which multiple battery cells are connected in series, a first blocking relay (BFET1) and a first discharging relay (DFET1) which are connected in series to a discharge line of the first battery cell group (Cell1), a first charging relay (CFET1) connected to a charge line of the first battery cell group (Cell1) and a first battery management unit (C1) which measures a current of the discharge line and the charge line to control the operations of the first blocking relay (BFET1), the first discharging relay (DFET1), and the first charging relay (CFET1), and a second battery pack (Pack2) having the same structure as and connected in parallel to the first battery pack (Pack1).

## Description

### BACKGROUND

### 1. Field

The present disclosure relates to a battery pack group and a driving method thereof.

### 2. Description of the Related Art

Unlike a primary battery that cannot be charged, a secondary battery is a rechargeable and dischargeable battery. A low-capacity secondary battery may be used for various portable small-sized electronic devices, such as a smartphone, a feature phone, a notebook computer, a digital camera, or a camcorder, and a high-capacity secondary battery is widely used as a power source for motor drives, such as those in hybrid vehicles or electric vehicles. These secondary batteries may include an electrode assembly having a positive electrode and a negative electrode, a case accommodating the electrode assembly, electrode terminals coupled to the electrode assembly, etc.

The above information disclosed in this Background section is only for enhancement of understanding of the background of the disclosure.

### SUMMARY

Embodiments include a battery pack group, the battery pack group including a first battery pack. The first battery pack includes a first battery cell group in which a plurality of battery cells are connected in series, a first blocking relay and a first discharging relay which are connected in series to a discharge line of the first battery cell group, a first charging relay connected to a charge line of the first battery cell group and a battery management unit which measures a current of the discharge line and the charge line to control the operations of the first blocking relay, the first discharging relay, and the first charging relay, and a second battery pack having the same structure as and connected in parallel to the first battery pack.

The first battery pack may include a first resistor electrically connected between a negative electrode and a negative electrode terminal of the first battery cell group, and the battery management unit may control the operations of the first blocking relay, the first discharging relay and the first charging relay by measuring the current flowing through the first resistor.

The first battery pack may further include a first fuse electrically connected between a positive electrode of the first battery cell group and the first blocking relay.

The first battery pack may further include a first diode that is electrically connected between the first charging relay and a positive charging terminal and blocks a current from flowing from the first charging relay to the positive charging terminal.

In the first battery pack, the first blocking relay, the first discharging relay, and the first charging relay may be N-type MOSFETs, and a first electrode may be a source electrode, a second electrode may be a drain electrode and a control electrode may be a base electrode.

In the first blocking relay of the first battery pack, the first electrode may be electrically connected to a positive electrode of the first battery cell group and the first electrode of the first charging relay, the second electrode may be electrically connected to the second electrode of the first discharging relay and the control electrode may be connected to a first battery management unit.

In the first discharging relay of the first battery pack, the first electrode may be electrically connected to a positive discharge terminal of the discharge line, the second electrode may be electrically connected to the second electrode of the first blocking relay and the control electrode may be electrically connected to the first battery management unit.

In the first charging relay of the first battery pack, the first electrode may be electrically connected to a positive electrode of the first battery cell group and the first electrode of the first blocking relay, the second electrode may be electrically connected to the second electrode of the first diode and the control electrode may be electrically connected to the first battery management unit.

If a first battery pack and a second battery pack are connected in parallel, a first discharging relay of the first battery pack and a second discharging relay of the second battery pack may be turned on, and a first blocking relay and a first charging relay of the first battery pack and a second blocking relay and a second charging relay of the second battery pack may be turned off.

According to another aspect of the present invention a driving method of the battery pack group is provided, wherein, when a first battery pack and a second battery pack are connected in parallel, a first discharging relay of the first battery pack and a second discharging relay of the second battery pack are turned on, and a first blocking relay and a first charging relay of the first battery pack and a second blocking relay and a second charging relay of the second battery pack are turned off.

If an electronic device is connected to input/output terminals of the first battery pack and the second battery pack, a blocking relay of the battery pack having a larger charging voltage, of the first battery pack and the second battery pack, may be turned on, and thus the discharging current flowing through a discharge line may be transmitted to the electronic device.

A battery management unit of the battery pack having a larger charging voltage, of the first battery pack and the second battery pack, may turn on the respective blocking relay when the discharging current measured in a resistor is maintained above a reference current value for a reference time, and thus the electronic device may be driven through the voltage discharged from the battery pack.

If the charging voltages of the first battery pack and the second battery pack are the same, both the first battery pack and the second battery pack may be discharged.

If an electronic device is connected to input/output terminals of the first battery pack and the second battery pack, and the charging voltages of the first battery pack and the second battery pack are the same, both the first battery pack and the second battery pack may be discharged.

If a charger is connected to input/output terminals of the first battery pack and the second battery pack, the first discharging relay and the second discharging relay may be turned off, and the charging relay of the battery pack having a smaller charging voltage, of the first battery pack and the second battery pack, may be turned on and charged through the charging current flowing through a charge line.

A battery management unit of the battery pack having a smaller charging voltage, of the first battery pack and the second battery pack, may turn on the charging relay if the charging current measured in a resistor is maintained above a reference current value for a reference time, and thus the battery pack may be charged through the voltage applied from the charger.

If the charging voltages of the first battery pack and the second battery pack are the same, both the first battery pack and the second battery pack may be charged.

If an electronic device is connected to input/output terminals of the first battery pack and the second battery pack, and the charging voltages of the first battery pack and the second battery pack are the same, both the first battery pack and the second battery pack may be charged.

### BRIEF DESCRIPTION OF DRAWINGS

Features will become apparent to those of ordinary skill in the art by describing in detail exemplary embodiments with reference to the attached drawings, in which:
FIG. 1 is a structural diagram showing a battery pack group according to one or more embodiments of the present disclosure.
FIG. 2 is a structural diagram showing the flow of current during a discharging operation after a first battery pack and a second battery pack shown in FIG. 1 are connected in parallel according to one or more embodiments.
FIGS. 3A and 3B are graphs showing discharging currents according to charging voltages of a first battery pack and a second battery pack over time according to one or more embodiments.
FIG. 4 is a structural diagram showing the flow of current during a charging operation after a first battery pack and a second battery pack shown in FIG. 1 are connected in parallel according to one or more embodiments.
FIG. 5 is a graph showing charging currents according to charging voltages of a first battery pack and a second battery pack over time according to one or more embodiments.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

Prior to giving the following detailed description of the present disclosure, it should be noted that the terms and words used in the specification and the claims should not be construed as being limited to ordinary meanings or dictionary definitions but should be construed in a sense and concept consistent with the technical idea of the present disclosure, on the basis that the inventor can properly define the concept of a term to describe the disclosure in the best way possible. Therefore, the embodiments described in the specification and the configurations described in the drawings are only the most preferred embodiments of the present disclosure, and do not represent all of the technical ideas of the present disclosure. It is to be understood that there may be various equivalents and variations in place of them at the time of filing the present application.

In addition, as used herein, the terms "comprise or include" and/or "comprising or including," when used in this specification, specify the presence of stated features, numbers, steps, operations, elements, and/or components, but do not preclude the presence or addition of one or more other features, numbers, steps, operations, elements, components, and/or groups thereof.

A reference to two objects in comparison being the same may mean that they are substantially the same. Thus, the wording "substantially the same" may include cases where the same is considered to be a low level in the related art, for example, a deviation within 5%. In addition, when any of parameters is referred to as being uniform in a given region, it may mean that the parameter is uniform from an average perspective.

It will be understood that, although the terms "first," "second," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, unless otherwise defined, a first element, component, region, layer or section described below could be termed a second element, component, region, layer or section, without departing from the scope of the present disclosure.

Throughout the specification, the singular forms "a" and "an" are intended to include the plural forms as well, unless the context clearly indicates otherwise.

The arrangement of an arbitrary component on the "upper portion (or lower portion)" or "upper (or lower)" of a component means that an arbitrary component is placed in contact with the upper (or lower) surface of the component. In addition, it may mean that other components may be interposed between the component and any component disposed on (or under) the component.

Also, it will be understood that when an element is referred to as being "on," "connected to," or "coupled to," another element, these elements can be directly connected or coupled to each other, another intervening element may be present therebetween, or the respective elements may be connected, coupled, or linked to each other through another elements.

As used herein, the term "and/or" includes any and all combinations of one or more of the associated listed items. Further, the use of "may" when describing embodiments of the present disclosure refers to "one or more embodiments of the present disclosure." Expressions such as "at least one of," when preceding a list of elements, modify the entire list of elements and do not modify the individual elements of the list.

Throughout the specification, the expression "A and/or B" means A, B, or A and B, unless otherwise defined, and the expression "C to D" means C or more and D or less, unless otherwise defined.

When the phrase "at least one of A, B, and C," "at least one of A, B, or C," "at least one selected from the group consisting of A, B, and C," or "at least one selected from A, B, and C" is used to specify a list of elements A, B, and C, the phrase can refer to any and all suitable combinations.

As used herein, the terms "use" may be considered synonymous with the term "utilize". As used herein, the term "substantially," "about," and similar terms are used as terms of approximation and not as terms of degree, and are intended to account for the inherent deviations in measured or calculated values that would be recognized by those of ordinary skill in the art.

In the drawings, the relative sizes of elements, layers, and regions may be exaggerated for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features.

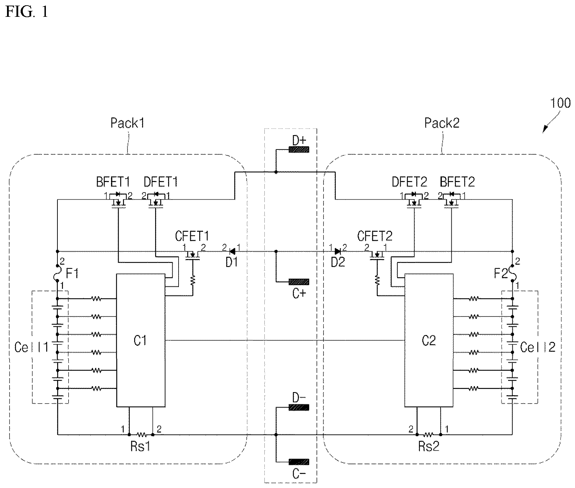

FIG. 1 is a structural diagram showing a battery pack group according to one or more embodiments of the present disclosure.

The battery pack group 100 of FIG. 1 may include a first battery pack Pack1 and a second battery pack Pack2 connected in parallel to the first battery pack Pack1. Here, the first battery pack Pack1 and the second battery pack Pack2 may be separate battery packs designed with the same structure and circuitry. The battery pack group 100 may be used to increase the capacity of the battery pack by installing an additional battery pack in, for example, a vacuum cleaner or electric bicycle equipped with one battery pack, but the applications of the battery pack(s) may vary.

The first battery pack Pack1 may include a first battery cell group Cell1 having a plurality of battery cells connected in series, a first discharging relay DFET1 and a first blocking relay BFET1 connected in series to a discharge line, and a first charging relay CFET1 and a first diode D1 connected in series to a charge line.

The first battery pack Pack1 may further include a first battery management unit C1 that controls the operations of the first discharging relay DFET1, the first blocking relay BFET1, and the first charging relay CFET1. The first battery cell group Cell1 may further include a first resistor Rs1 that detects a current flowing in the charge/discharge line, and a first fuse F1 connected in series to the first battery cell group Cell1.

The first battery pack Pack1 may supply a current to an electronic device through input and output terminals, which are a positive discharging terminal D+, a positive charging terminal C+, and negative electrode terminals D- and C-, or may be charged by receiving a current through a charger.

When the first battery pack Pack1 is discharged, a current may flow between the positive discharging terminal D+, which is a discharge line, and the negative electrode terminals D- and C-. In addition, when the first battery pack Pack1 is charged, a current may flow between the positive charging terminal C+, which is a charge line, and the negative electrode terminals D- and C-. The discharge line may have the negative electrode terminals D- and C-, the first resistor Rs1, the first battery cell group Cell1, the first fuse F1, the first blocking relay BFET1, the first discharging relay DFET1, and the positive discharging terminal D+ sequentially located therein. The charge line may have the positive charging terminal C+, the first diode D1, the first charging relay CFET1, the first fuse F1, the first battery cell group Cell1, the first resistor Rs1, and the negative electrode terminals D- and C- sequentially located therein. The sequential locations may be locations in the same direction as the current flow direction.

For example, if a charger is connected between input and output terminals of the first battery pack Pack1, the first battery pack Pack1 may be charged through the charge line. In addition, the first battery pack Pack1 may supply a voltage to an electronic device through discharging when the electronic device connected to the input/output terminal is driven. When the first battery pack Pack1 is connected in parallel to the second battery pack Pack2, the positive discharging terminal D+, the positive charging terminal C+, and the negative electrode terminals D- and C- of the first battery pack Pack1 may each be electrically connected to the second battery pack Pack2.

The driving method after the first battery pack Pack1 and the second battery pack Pack2 are connected in parallel will now be described in detail.

Each of the battery cells included in the first battery cell group Cell1 may be a circular type, a square type, or a pouch type battery cell depending on the battery type. In the first battery cell group Cell1, the negative electrode may be electrically connected to a first electrode 1 of the first resistor Rs1, and the positive electrode may be electrically connected to a first electrode 1 of the first fuse F1. The first battery cell group Cell1 may be charged when a current is supplied through the charge line, and may be discharged by supplying a voltage to the device when a current flows through the discharge line.

The first electrode 1 of the first resistor Rs1 may be electrically connected to the negative electrode of the first battery cell group Cell1 and the first battery management unit C1, and the second electrode 2 may be connected to the negative electrode terminals D- and C- and the first battery management unit C1. The first battery management unit C1 may check whether a current flows through the charge line and the discharge line through the first resistor Rs1.

The first battery pack Pack1 may further include a detection device for detecting the state (voltage, current, temperature, etc.) of the first battery pack Pack1, in addition to the first resistor Rs1 that detects the current flowing in the charge line and in the discharge line. The detection device may detect the state of each battery cell included in the first battery cell group Cell1 constituting the first battery pack Pack1. The first resistor Rs1 and the detection device may be electrically connected to the first battery management unit C1, and the state of the first battery pack Pack1, measured by the first resistor Rs1 and the detection device, may be transmitted.

The first battery management unit C1 may control the operation of the first battery pack Pack1 by receiving the state of the first battery pack Pack1 transmitted from the first resistor Rs1 and the detection device. Based on the state information of the first battery pack Pack1 received from the first resistor Rs1 and the detection device, the first battery management unit C1 may monitor and calculate the state (voltage, current, temperature, state of charge (SOC), state of health (SOH), etc.) of the first battery cell group Cell1. In addition, the first battery management unit (C1) may perform control functions (e.g., temperature control, balancing control, charging/discharging control, etc.) and protection functions (e.g., prevention of over-discharge, over-charge or over-current, short circuit, fire extinguishing function, etc.).

The first battery management unit C1 may be electrically connected to a control electrode of the first discharging relay DFET1, a control electrode of the first blocking relay BFET1 and a control electrode of the first charging relay CFET1 to control the operations thereof. The first discharging relay DFET1, the first blocking relay BFET1 and the first charging relay CFET1 may be semiconductor switches such as a metal oxide semiconductor field effect transistor (MOSFET). In some embodiments, the first discharging relay DFET1, the first blocking relay BFET1 and the first charging relay CFET1 may be N-type MOSFETs. In the following description, in each of the first discharging relay DFET1, the first blocking relay BFET1, and the first charging relay CFET1, the first electrode 1 may be a source electrode, the second electrode 2 may be a drain electrode, and the control electrode may be a base electrode.

The first electrode 1 of the first discharging relay DFET1 may be electrically connected to the positive discharging terminal D+, the second electrode 2 may be electrically connected to the second electrode 2 of the first blocking relay BFET1, and the control electrode may be electrically connected to the first battery management unit C1. The first discharging relay DFET1 may be turned on or off under the control of the first battery management unit C1.

The first electrode 1 of the first blocking relay BFET1 may be electrically connected to the second electrode 2 of the first fuse F1 and the first electrode 1 of the first charging relay CFET1, the second electrode 2 may be electrically connected to the second electrode 2 of the first discharging relay DFET1 and the control electrode may be electrically connected to the first battery management unit C1. The first blocking relay BFET1 may be turned on or off under the control of the first battery management unit C1. The first blocking relay BFET1 and the first discharging relay DFET1 may connect or block the current flowing through the discharge line.

The first electrode 1 of the first charging relay CFET1 may be electrically connected to the second electrode 2 of the first fuse F1 and the first electrode 1 of the first blocking relay BFET1, the second electrode 2 of the first charging relay CFET1 may be electrically connected to the second electrode 2 of the first diode D1 and the control electrode may be electrically connected to the first battery management unit C1. The first charging relay CFET1 may be turned on or off under the control of the first battery management unit C1. The first charging relay CFET1 may connect or block the current flowing through the charge line.

The first electrode 1 of the first fuse F1 may be electrically connected to the positive electrode of the first battery cell group Cell1, and the second electrode 2 may be connected to the first electrode 1 of the first charging relay CFET1 and the first electrode 1 of the first blocking relay BFET1. If an event occurs inside the first battery pack Pack1, the first fuse F1 may melt when an overcurrent flows and thus it may block the current from flowing through the charge line and the discharge line.

The first electrode 1 of the first diode D1 may be electrically connected to the positive charging terminal C+, and the second electrode 2 may be electrically connected to the second electrode 2 of the first charging relay CFET1. The first electrode 1 of the first diode D1 may be an anode and the second electrode 2 may be a cathode. The first diode D1 may prevent a current flowing from the first battery pack Pack1 to the positive charging terminal C+. That is, the first diode D1 may be provided to block an inrush current from flowing toward the second battery pack Pack2 when the voltage of the first battery pack Pack1 is higher than the voltage of the second battery pack Pack2 and the first diode D1 is connected in parallel to the second battery pack Pack2.

The first battery pack Pack1 can be discharged by being coupled to an electronic device as a single battery pack. The second battery pack Pack2 may be a separate battery pack designed with the same structure and circuitry as the first battery pack Pack1. The second battery pack Pack2 may be an auxiliary battery pack for an electronic device, and may be additionally installed in an electronic device coupled to the first battery pack Pack1 and electrically connected in parallel to the first battery pack Pack1. Of course, the opposite may also be possible. The electronic device may be able to operate by receiving a voltage from the first battery pack Pack1 or the second battery pack Pack2. That is, the first battery pack Pack1 and the second battery pack Pack2 may be used separately or connected in parallel to increase capacity.

The first battery pack Pack1 and the second battery pack Pack2 may be electrically connected or disconnected, and when being electrically connected, charging voltage levels thereof may be different. Of course, the charging voltage levels of the first battery pack Pack1 and the second battery pack Pack2 may instead be the same.

The charging or discharging driving method after the first battery pack Pack1 and the second battery pack Pack2 are connected in parallel in such a manner will now be described in detail.

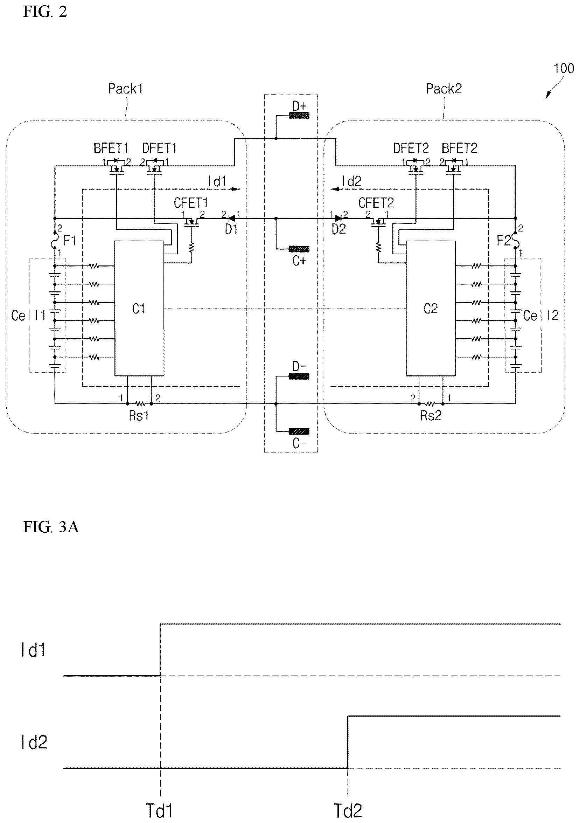

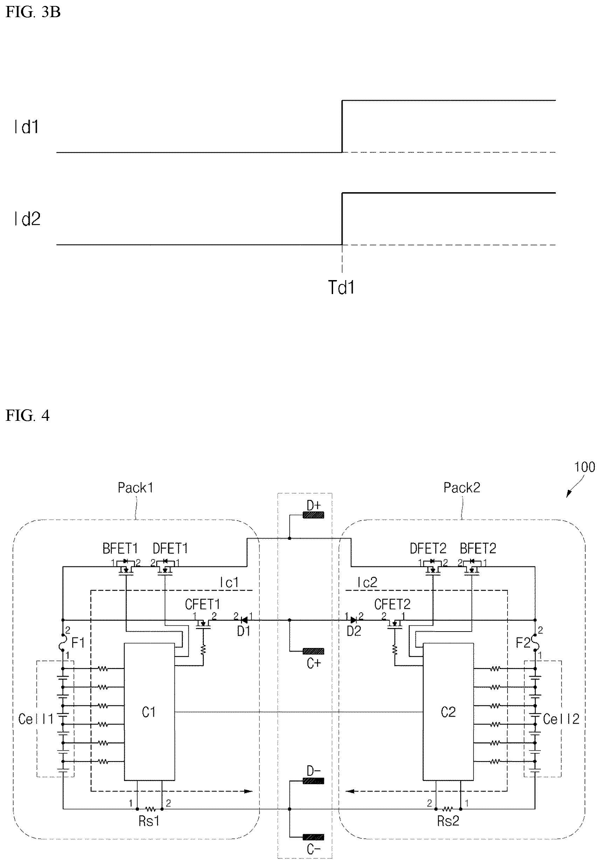

FIG. 2 is a structural diagram showing the flow of current during a discharging operation after a first battery pack Pack1 and a second battery pack Pack 2 shown in FIG. 1 are connected in parallel according to one or more embodiments. FIG. 3A is a graph showing the current values in the discharge lines of the first battery pack Pack1 and the second battery pack Pack2 over time when the charging voltages of the first battery pack Pack1 and the second battery pack Pack2 are different from each other, according to one or more embodiments. More specifically, FIG. 3A is a graph showing the current values in the discharge lines of the first battery pack Pack1 and the second battery pack Pack2 over time when the charging voltage of the first battery pack Pack1 is larger than the charging voltage of the second battery pack Pack2. FIG. 3B is a graph showing the current values in the discharge lines of the first battery pack Pack1 and the second battery pack Pack2 over time when the charging voltages of the first battery pack Pack1 and the second battery pack Pack2 are the same, according to one or more embodiments. Here, the charging voltage may be the state of charge (SOC) and/or the open circuit voltage (OCV) of the battery pack.

When the first battery pack Pack1 and the second battery pack Pack2 are connected in parallel, the first battery pack Pack1 may turn on (connect) the first discharging relay DFET1 through the first battery management unit C1 and may turn off (open) the first blocking relay BFET1 and the first charging relay CFET1. The second battery pack Pack2 may also turn on (connect) the second discharging relay DFET2 through the second battery management unit C2 and may turn off (open) the second blocking relay BFET2 and the second charging relay CFET2.

An electronic device may be connected to the input and output terminals of the first battery pack Pack1 and the second battery pack Pack2, and when the electronic device is driven, a voltage may be supplied to the electronic device by discharging the first battery pack Pack1 and/or the second battery pack Pack2.

After the first battery pack Pack1 and the second battery pack Pack2 are connected in parallel, in order to prevent an inrush current from occurring at an initial stage due to a difference in the charging voltage, only the discharging relay can be turned on in a state in which the blocking relay and the charging relay are turned off. In addition, since the discharging relay is turned off, the voltage can only be supplied to the electronic device from the battery pack having a larger charging voltage, of the first battery pack Pack1 and the second battery pack Pack2, or from both battery packs.

Referring to FIGS. 2 and 3A, a case where the charging voltage of the first battery pack Pack1 is larger than the charging voltage of the second battery pack Pack2, will now be described.

In order for an electronic device to be driven and supplied with a voltage, at a first discharging start point Td1 at which discharging of the first battery pack Pack1 and/or the second battery pack Pack2 is required, a first discharging current Id1 may flow through the discharge line of the first battery pack Pack1. Further, a second discharging current Id2 may not flow through the discharge line of the second battery pack Pack2, which has a smaller charging voltage than the first battery pack Pack1.

The first discharging current Id1 may be measured through the first resistor Rs1 of the first battery pack Pack1 and transmitted to the first battery management unit C1. That is, the first battery management unit C1 may confirm that the first discharging current Id1 flows through the first resistor Rs1. If the first discharging current Id1 is maintained for a reference time above a reference current value, the first battery management unit C1 may turn on the first blocking relay BFET1 to allow the electronic device to be driven through the voltage discharged from the first battery pack Pack1. For example, the reference current value may be 200 mA, and the reference time may be 250 ms, but the reference current value and the reference time may vary in various manners depending on the battery pack. That is, at the first discharging start point Td1, only the first battery pack Pack1 having a larger charging voltage, of the first battery pack Pack1 and the second battery pack Pack2, can be discharged.

In addition, if the charging voltage of the first battery pack Pack1 is larger than that of the second battery pack Pack2, the electronic device may be driven by the first discharging current Id1 of the first battery pack Pack1 after the first discharging start point Td1.

The first discharging current Id1 in the first battery pack Pack1 may flow through the negative electrode terminals D- and C-, the first resistor Rs1, the first battery cell group Cell1, the first fuse F1, the first blocking relay BFET1, the first discharging relay DFET1 and the positive discharging terminal D+, in that order.

As the charging voltage of the first battery pack Pack1 decreases due to discharging, and at a second discharging start point Td2 at which the charging voltage of the first battery pack Pack1 and the charging voltage of the second battery pack Pack2 become equal, the second discharging current Id2 may flow through the discharge line of the second battery pack Pack2. That is, at the second discharging start point Td2, the first discharging current Id1 may flow through the discharge line of the first battery pack Pack1, and the second discharging current Id2 may flow through the discharge line of the second battery pack Pack2. The electronic device may be supplied with the voltage from the first battery pack Pack1 and the second battery pack Pack2.

A driving method for allowing the second discharging current Id2 to flow through the discharge line of the second battery pack Pack2 may be similar to the driving method for allowing the first discharging current Id1 to flow through the discharge line of the first battery pack Pack1.

In this way, after the first battery pack Pack1 having a larger charging voltage, of the first battery pack Pack1 and the second battery pack Pack2, is discharged, when the charging voltages of the first battery pack Pack1 and the second battery pack Pack2 become equal, the first battery pack Pack1 and the second battery pack Pack2 can be discharged at the same time. Of course, when the charging voltage of the second battery pack Pack2 is larger than the charging voltage of the first battery pack Pack1, the second battery pack Pack2 may be discharged first. Then, when the charging voltages of the first battery pack Pack1 and the second battery pack Pack2 become equal, the first battery pack Pack1 and the second battery pack Pack2 can be discharged at the same time.

Referring to FIGS. 2 and 3B , a case where the charging voltage of the first battery pack Pack1 is the same as that of the second battery pack Pack2 will be described.

In order for an electronic device to be driven and supplied with a voltage, at the first discharging start point Td1 at which discharging of the first battery pack Pack1 and/or the second battery pack Pack2 is required, the first discharging current Id1 may flow through the discharge line of the first battery pack Pack1 and the second discharging current Id2 may flow through the discharge line of the second battery pack Pack2.

The driving method for allowing the first discharging current Id1 to flow through the discharge line of the first battery pack Pack1 and the driving method for allowing the second discharging current Id2 to flow through the discharge line of the second battery pack Pack2 may be similar to the driving method for allowing the first discharging current Id1 to flow through the discharge line of the first battery pack Pack1 in the description of FIG. 3A.

That is, if the charging voltages of the first battery pack Pack1 and the second battery pack Pack2 are equal, the electronic device may be driven by the first discharging current Id1 of the first battery pack Pack1 and the second discharging current Id2 of the second battery pack Pack2 after first discharging start point Td1.

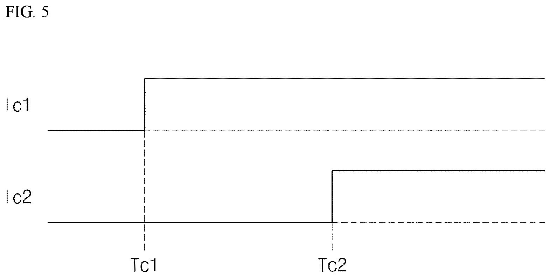

FIG. 4 is a structural diagram showing the flow of current during a charging operation after a first battery pack Pack1 and a second battery pack Pack2 shown in FIG. 1 are connected in parallel. FIG. 5 is a graph showing current values according to charging voltages in the charge lines of a first battery pack Pack1 and a second battery pack Pack2 over time when the charge voltages of the first battery pack Pack1 and the second battery pack Pack2 are different from each other, in accordance with one or more embodiments. More specifically, FIG. 5 is a graph showing current values according to charging voltages in the charge lines of a first battery pack Pack1 and a second battery pack Pack2 over time when the charge voltage of the first battery pack Pack1 is smaller than that of the second battery pack Pack2.

While the first battery pack Pack1 and the second battery pack Pack2 are connected in parallel, the first battery pack Pack1 may turn on (connect) the first discharging relay DFET1 through the first battery management unit C1 and may turn off (open) the first blocking relay BFET1 and the first charging relay CFET1. In addition, the second battery pack Pack2 may also turn on (connect) the second discharging relay DFET2 through the second battery management unit C2 and may turn off (open) the second blocking relay BFET2 and the second charging relay CFET2.

An electronic device may be connected to the input and output terminals of the first battery pack Pack1 and the second battery pack Pack2, and a voltage may be supplied to the first battery pack Pack1 and the second battery pack Pack2 through a charger. When the charger is connected to the input and output terminals of the first battery pack Pack1 and the second battery pack Pack2, the first discharging relay DFET1 and the second discharging relay DFET2 may be turned off.

As the charger is connected to the input and output terminals, a first charging current Ic1 may flow through the charge line of the first battery pack Pack1 at a first charging start point Tc1 at which charging of the first battery pack Pack1 and/or the second battery pack Pack2 is required. In some embodiments, a second charging current Ic2 may not flow through the charge line of the second battery pack Pack2, which has a larger charging voltage than the first battery pack Pack1. In that case, a second diode D2 of the second battery pack Pack2 may prevent a reverse current of the second battery pack Pack2, which has a larger charging voltage, from being applied through the charge line of the first battery pack Pack1 connected in parallel.

In the first battery pack Pack1, the first charging current Ic1 may flow through the positive charging terminal C+, the first diode D1, the first charging relay CFET1, the first fuse F1, the first battery cell group Cell1, the first resistor Rs1 and the negative electrode terminals D- and C-, in that order.

The first charging current Ic1 may be measured through the first resistor Rs1 of the first battery pack Pack1 and transmitted to the first battery management unit C1. That is, the first battery management unit C1 may confirm that the first charging current Ic1 flows through the first resistor Rs1. When the first charging current Ic1 is maintained for a reference time above a reference current value, the first battery management unit C1 may turn on the first charging relay CFET1 to allow the voltage supplied from the charger to be transmitted to the first battery pack Pack1, and thus the first battery pack Pack1 can be charged. In an example embodiment, the reference current value may be 200 mA, and the reference time may be 250 ms. However, the reference current value and the reference time may vary in various manners depending on the battery pack. That is, at the first charging start point Tc1, only the first battery pack Pack1 having a smaller charging voltage, of the first battery pack Pack1 and the second battery pack Pack2, can be charged by the current supplied from the charger.

As the charging voltage of the first battery pack Pack1 increases due to charging, and at a second charging start point Tc2 at which the charging voltage of the first battery pack Pack1 and the charging voltage of the second battery pack Pack2 become equal, the second charging current Ic2 may flow through the charge line of the second battery pack Pack2. That is, at the second charging start point Tc2, the first charging current Ic1 may flow through the charge line of the first battery pack Pack1, and the second charging current Ic2 may flow through the charge line of the second battery pack Pack2. When the charging voltages of the first battery pack Pack1 and the second battery pack Pack2 are equal, the first battery pack Pack1 and the second battery pack Pack2 can be charged at the same time through the charger.

The present disclosure relates to a battery pack group and driving method thereof, in which two battery packs may be used by being connected in parallel to increase the capacity, and even if the charging voltages of the two battery packs are different, charging and discharging are simultaneously enabled by allowing the two battery packs to have the same charging voltage by sequentially discharging or charging.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A battery pack group (100), comprising:
a first battery pack (Pack1) including:
a first battery cell group (Cell 1) in which a plurality of battery cells are connected in series;
a first blocking relay (BFET1) and a first discharging relay (DFET1) which are connected in series to a discharge line of the first battery cell group (Cell1);
a first charging relay (CFET1) connected to a charge line of the first battery cell group (Cell1); and
a first battery management unit (C1) which is adapted to measure a current of the discharge line and the charge line to control the operations of the first blocking relay (BFET1), the first discharging relay (DFET1), and the first charging relay (CFET1); and
a second battery pack (Pack2) having the same structure as the first battery pack (Pack1) and connected in parallel to the first battery pack (Pack1).

2. The battery pack group (100) as claimed in claim 1, wherein the first battery pack (Pack1) comprises a first resistor (Rs1) electrically connected between a negative electrode of the first battery cell group (Cell1) and a negative electrode terminal (C-, D-), and the battery management unit (C1) is adapted to control the operations of the first blocking relay (BFET1), the first discharging relay (DFET1), and the first charging relay (CFET1) by measuring the current flowing through the first resistor (Rs1).

3. The battery pack group (100) as claimed in claim 1 or 2, wherein the first battery pack (Pack1) further comprises:
a first fuse (F1) electrically connected between a positive electrode of the first battery cell group (Cell1) and the first blocking relay (BFET1); and/or
a first diode (D1) that is electrically connected between the first charging relay (CFET1) and a positive charging terminal (C+) and is configured to block a current from flowing from the first charging relay (CFET1) to the positive charging terminal (C+).

4. The battery pack group (100) as claimed in one of the preceding claims, wherein in the first battery pack (Pack1), the first blocking relay (BFET1), the first discharging relay (DFET1), and the first charging relay (CFET1) are N-type MOSFETs, and a first electrode (1) is a source electrode, a second electrode (2) is a drain electrode, and a control electrode is a base electrode.

5. The battery pack group (100) as claimed in claim 4, wherein in the first blocking relay (BFET1) of the first battery pack (Pack1), the first electrode (1) is electrically connected to a positive electrode of the first battery cell group (Cell1) and the first electrode (1) of the first charging relay (CFET1), the second electrode (2) is electrically connected to the second electrode (2) of the first discharging relay (DFET1), and the control electrode is connected to the first battery management unit (C1).

6. The battery pack group (100) as claimed in claim 4 or 5, wherein in the first discharging relay (DFET1) of the first battery pack (Pack1), the first electrode (1) is electrically connected to a positive discharging terminal (D+) of the discharge line, the second electrode (2) is electrically connected to the second electrode (2) of the first blocking relay (BFET1) and the control electrode is electrically connected to the first battery management unit (C1).

7. The battery pack group (100) as claimed in one of claims 4 to 6, wherein in the first charging relay (CFET1) of the first battery pack (Pack1), the first electrode (1) is electrically connected to a positive electrode of the first battery cell group (Cell1) and the first electrode (1) of the first blocking relay (BFET1), the second electrode (2) is electrically connected to the second electrode (2) of the first diode (D1) and the control electrode is electrically connected to the first battery management unit (C1).

8. A driving method of the battery pack group (100) of one of claims 1 through 7, wherein, when a first battery pack (Pack1) and a second battery pack (Pack2) are connected in parallel, a first discharging relay (DFET1) of the first battery pack (Pack1) and a second discharging relay (DFET2) of the second battery pack (Pack2) are turned on, and a first blocking relay (BFET1) and a first charging relay (CFET1) of the first battery pack (Pack1) and a second blocking relay (BFET2) and a second charging relay (CFET2) of the second battery pack (Pack2) are turned off.

9. The driving method as claimed in claim 8, wherein, when an electronic device is connected to input/output terminals of the first battery pack (Pack1) and the second battery pack (Pack2), a blocking relay (BFET1, BFET2) of the battery pack having a larger charging voltage, of the first battery pack (Pack1) and the second battery pack (Pack2), is turned on, and thus the respective discharging current (Id1, Id2) flowing through a discharge line is transmitted to the electronic device.

10. The driving method as claimed in claim 9, wherein a battery management unit (C1, C2) of the battery pack having a larger charging voltage, of the first battery pack (Pack1) and the second battery pack (Pack2), turns on the respective blocking relay (BFET1, BFET2) when the discharging current measured in a resistor (Rs1, Rs2) is maintained above a reference current value for a reference time, and thus the electronic device is driven through the voltage discharged from the battery pack (Pack1, Pack2).

11. The driving method as claimed in claim 9 or 10, wherein, if the charging voltages of the first battery pack (Pack1) and the second battery pack (Pack2) are the same, both the first battery pack (Pack1) and the second battery pack (Pack2) are discharged.

12. The driving method as claimed in one of claims 8 to 11, wherein, if a charger is connected to input/output terminals of the first battery pack (Pack1) and the second battery pack (Pack2), the first discharging relay (DFET1) and the second discharging relay (DFET2) are turned off, and the charging relay (CFET1, CFET2) of the battery pack having a smaller charging voltage, of the first battery pack (Pack1) and the second battery pack (Pack2), is turned on and charged through the charging current flowing through a charge line.

13. The driving method as claimed in claim 12, wherein a battery management unit (C1, C2) of the battery pack having a smaller charging voltage, of the first battery pack (Pack1) and the second battery pack (Pack2), turns on the respective charging relay (CFET1, CFET2) when the charging current measured in a resistor (Rs1, Rs2) is maintained above a reference current value for a reference time, and thus the battery pack (Pack1, Pack2) is charged through the voltage applied from the charger.

14. The driving method as claimed in claim 12 or 13, wherein, if the charging voltages of the first battery pack (Pack1) and the second battery pack (Pack2) are the same, both the first battery pack (Pack1) and the second battery pack (Pack2) are charged.

15. The driving method as claimed in one of claims 8 to 14, wherein
if an electronic device is connected to input/output terminals of the first battery pack (Pack1) and the second battery pack (Pack2), and the charging voltages of the first battery pack (Pack1) and the second battery pack (Pack2) are the same, both the first battery pack (Pack1) and the second battery pack (Pack2) are discharged; and/or
if a charger is connected to input/output terminals of the first battery pack (Pack1) and the second battery pack (Pack2), and the charging voltages of the first battery pack (Pack1) and the second battery pack (Pack2) are the same, both the first battery pack (Pack1) and the second battery pack (Pack2) are charged.
